# EUROPEAN PATENT APPLICATION

(11) **EP 4 839 073 A2**
(43) Date of publication of application: **11.11.2026**
(21) Application number: 26208351.2
(22) Date of filing: 15.08.2022
(51) Int. Cl.: H10P 72/30

(54) **DEVICE FOR CHANGING THE TEMPERATURE OF A WAFER**

(30) Priority: 18.08.2021 CN 202121946653 U; 23.06.2022 GB 202209238
(62) Document number(s) of the earlier application(s) in accordance with Art. 76 EPC: 22765779.8 / 4 388 580
(71) Applicant: Lam Research Corporation, Fremont, CA 94538 (US)
(72) Inventor: ELLIOTT, Gregor Robert, Bristol, BS32 4SH (GB); WILBY, Robert John, Bristol, BS32 4SH (GB); MOOSAVI, Abraham, Brstol, BS32 4SH (GB); OWENS, Sam, Bristol, BS32 4SH (GB)
(74) Representative: Mewburn Ellis LLP

(57) **Abstract**

A device for changing the temperature of a wafer, The device comprising: a surface that is configured to support the wafer and to exchange heat with the wafer, and a space that is configured to receive at least a distal part of an end effector, which is used to support the wafer from beneath, when the end effector is used to lower the wafer onto the surface, wherein the space extends from or to a side of the device; and wherein the space is configured so that the at least a distal part of the end effector can be withdrawn from the space from the side of the device.

## Description

### Field of the invention

The present invention relates to a device for changing the temperature of a wafer, and to a wafer mass metrology apparatus comprising such a device.

### Background of the invention

Microelectronic devices are fabricated on semiconductor (e.g. silicon) wafers using a variety of techniques, e.g. including deposition techniques (CVD, PECVD, PVD, etc.) and removal techniques (e.g. chemical etching, CMP, etc.). Semiconductor wafers may be further treated in ways that alter their mass, e.g. by cleaning, ion implantation, lithography and the like.

Depending on the device being manufactured, each semiconductor wafer may be passed sequentially through hundreds of different processing steps to build up and/or to remove the layers and materials necessary for its ultimate operation. In effect, each semiconductor wafer is passed down a production line.

The cost and complexity of the processing steps required to produce a completed silicon wafer, together with the time that it takes to reach the end of the production line where its operation can be properly assessed, has led to a desire to monitor the operation of the equipment on the production line and the quality of the wafers being processed throughout processing, so that confidence in the performance and yield of the final wafers may be assured.

Wafer treatment techniques typically cause a change in mass of the semiconductor wafer. The configuration of the changes to the semiconductor wafer are often vital to the functioning of the device, so it is desirable for quality control purposes to assess wafers during production in order to determine whether they have the correct configuration.

Measuring the change in mass of a wafer either side of a processing step is an attractive method for implementing product wafer metrology. It is relatively low cost, high speed and can accommodate different wafer circuitry patterns automatically. In addition, it can often provide results of higher accuracy than alternative techniques. The wafer in question is weighed before and after the processing step of interest. The change in mass is correlated to the performance of the production equipment and/or the desired properties of the wafer.

Processing steps carried out on semiconductor wafers can cause very small changes in the mass of the semiconductor wafer, which it may be desirable to measure with high accuracy. For example, removing a small amount of material from the surface of the semiconductor wafer may reduce the mass of the semiconductor wafer by a few milligrams, and it may be desirable to measure this change with a resolution of the order of ±100µg or better.

At these high levels of measurement accuracy, errors in the measurement output caused by temperature variations in the semiconductor wafers being measured and/or in the temperature of the measurement apparatus may become significant.

For example, if the semiconductor wafer has a higher temperature than a measurement chamber of the measurement apparatus, air currents (e.g. convection currents) may be generated in the air in the measurement chamber, which may affect the measurement output. In addition, the air in the measurement chamber may be heated, changing its density and pressure and therefore the buoyancy force exerted on the semiconductor wafer by the air. This may also affect the measurement output.

The temperature of a semiconductor wafer immediately after it has been processed in a production line may be 400-500°C or higher. After processing the semiconductor wafer may be loaded into a Front Opening Unified Pod (FOUP) together with other recently processed semiconductor wafers for transportation between different processing locations of the production line. When the FOUP arrives at a weighing device for weighing the semiconductor wafers, the temperature of the semiconductor wafers may still be high, for example 70°C or higher. In contrast, the temperature of the weighing device may be approximately 20°C. Therefore, there may be a significant temperature difference between the semiconductor wafers and the weighing device.

WO02/03449 describes a semiconductor wafer mass metrology method that aims to reduce errors in the measurement output caused by temperature variations in the measurement balance or the semiconductor wafers being measured. In the method described in WO02/03449, a semiconductor wafer is removed from a FOUP and placed on a passive thermal transfer plate that is thermally coupled to a chamber of a weighing apparatus before it is placed on a measurement area of the weighing apparatus. The passive thermal transfer plate equalises the temperature of the semiconductor wafer to the temperature of the chamber to within ±0.1°C.

WO2015/082874 discloses that there may a significant heat load on the chamber of the weighing apparatus in the method described in WO02/03449. This heat load may cause the temperature of the weighing apparatus (e.g. the temperature of a balance of the weighing apparatus) to increase or to become non-uniform, which may cause corresponding errors in the weight measurements performed by the weighing apparatus, as discussed above.

WO2015/082874 discloses removing the bulk of the heat load from the semiconductor wafer before using the thermal transfer plate to equalise the temperature of the semiconductor wafer to the temperature of the weighing apparatus, to reduce the heat load on the weighing apparatus.

In an embodiment disclosed in WO2015/082874, the bulk of the heat load is removed from the semiconductor wafer using an active thermal transfer plate in which the heat load is actively dissipated using thermoelectric devices, and then the temperature of the semiconductor wafer is subsequently equalised to the temperature of the measurement chamber using a passive thermal transfer plate that is mounted on an upper surface of the measurement chamber and in thermal equilibrium with the measurement chamber.

Typically, a robotic arm with a suitable end effector (for example a two-pronged end effector) is used to transport a wafer to and from a thermal transfer plate, for example between the thermal transfer plate and the measurement chamber. In particular, the end effector contacts an underside of the wafer to support the wafer from beneath the wafer.

A thermal transfer plate previously used by the applicant has a plurality of actuator pins for receiving the wafer from an end effector of a robotic arm, which supports the wafer from beneath, and for lowering the wafer onto a heat transfer surface of the thermal transfer plate.

In particular, each of the plurality of actuator pins is movable between a wafer-receiving position where the actuator pin protrudes above the heat transfer surface of the thermal transfer plate, and a retracted position where the actuator pin is retracted into the thermal transfer plate and does not protrude above the heat transfer surface.

When loading a wafer onto the thermal transfer plate, the end effector of the robotic arm is used to lower the wafer towards the heat transfer surface of the thermal transfer plate with the plurality of actuator pins in the wafer-receiving positions.

When the end effector is a predetermined distance above the heat transfer surface of the thermal transfer plate, the underside of the wafer comes into contact with the plurality of actuator pins. Therefore, when the end effector is less than the predetermined distance above the heat transfer surface of the thermal transfer plate, the wafer is fully supported by the plurality of actuator pins and is no longer supported by the end effector. The end effector is then moved laterally relative to the thermal transfer plate and the wafer so that the end effector is no longer beneath the wafer.

Subsequently, the plurality of actuator pins are moved to the retracted positions, so that the wafer is placed on the heat transfer surface of the thermal transfer plate and is supported by the heat transfer surface of the thermal transfer plate.

The thermal transfer plate has a vacuum clamp that is used to clamp the wafer on the heat transfer surface of the thermal transfer plate once the wafer is placed on the heat transfer surface. For example, the heat transfer surface may have one or more openings through which air is sucked by one or more pumps so as to create a low pressure between the heat transfer surface and the wafer so as to clamp the wafer to the heat transfer surface.

The wafer is clamped to the heat transfer surface of the thermal transfer plate for a period of time sufficient to achieve a desired temperature of the wafer, for example a period of time for the temperature of the wafer to become substantially equal to the temperature of the thermal transfer plate, and/or a predetermined period of time.

Subsequently, the vacuum clamping of the wafer is stopped, and the plurality of actuator pins are moved to the wafer-receiving positions where the wafer is supported a predetermined distance above the heat transfer surface of the thermal transfer plate.

An end effector of a robotic arm is then moved laterally relative to the wafer and the thermal transfer plate so that the end effector is positioned underneath the wafer, and the end effector is then used to lift the wafer off the thermal transfer plate.

While this arrangement for placing the wafer on the thermal transfer plate is sufficient for many applications, the present inventors have realised that this arrangement may cause potential problems in some cases.

For example, the present inventors have realised that actuator pins, or other similar intermediate mechanisms for receiving the wafer from the end effector of the robotic arm and subsequently lowering the wafer onto the heat transfer surface, take up space in the thermal transfer plate that may affect heat transfer within the thermal transfer plate. For example, holes in the thermal transfer plate for the actuator pins may act as a thermal break in the thermal transfer plate. Such a thermal break may negatively affect heat transfer within the thermal transfer plate, such that there are temperature variations across the thermal transfer plate, and/or such that the thermal transfer plate does not have a desired temperature.

In addition, or alternatively, the present inventors have realised that the actuator pins, or other similar intermediate mechanisms for receiving the wafer from the end effector of the robotic arm and subsequently lowering the wafer onto the surface, may generate heat, which may cause undesirable temperature changes and/or temperature variations in the thermal transfer plate which may lead to subsequent measurement errors when the wafer is transferred to a weighing apparatus.

In addition, the present inventors have realised that failure of one or more of the actuator pins may result in the wafer being at an angle on the thermal transfer plate, such that the wafer is tilted. This may result in poor thermalisation of the wafer due to poor contact between the wafer and the surface of the thermal transfer plate. This may also lead to breakage of the wafer or damage to the wafer when an end effector is moved to lift the wafer off the surface of the thermal transfer plate.

### Summary of the invention

The present invention may address one or more of these problems.

At its most general, the present invention relates to providing a space that is configured to receive an end effector that supports the wafer from beneath when the end effector is used to lower the wafer onto the heat transfer surface. Therefore, the end effector can be used to directly place the wafer onto the heat transfer surface, with the end effector being received in the space when the wafer is placed onto the heat transfer surface. Therefore, it is not necessary to provide actuator pins, or other similar intermediate mechanisms for receiving the wafer from the end effector and subsequently lowering the wafer onto the surface, as described above.

According to a first aspect of the present invention there is provided a device for changing the temperature of a wafer, the device comprising:
a surface that is configured to support the wafer and to exchange heat with the wafer, and
a space that is configured to receive at least a distal part of an end effector, which is used to support the wafer from beneath, when the end effector is used to lower the wafer onto the surface,
wherein the space extends from or to a side or edge of the device; and
wherein the space is configured so that the at least a distal part of the end effector can be withdrawn from the space from the side or edge of the device.

In the device according to the first aspect of the present invention, when the end effector is used to lower the wafer onto the surface, at least the distal part of the end effector is received in the space. Therefore, the end effector can be used to directly lower the wafer onto the surface, and it is not necessary to provide actuator pins, or other similar intermediate mechanisms for receiving the wafer from the end effector and subsequently lowering the wafer onto the surface, as described above.

In addition, not providing the actuator pins, or other similar intermediate mechanisms for receiving the wafer from the end effector and subsequently lowering the wafer onto the surface, may mean that it is possible for the device to be thinner than if these components were included.

Furthermore, the space extends from or to a side or edge of the device, and the space is configured so that the at least a distal part of the end effector can be withdrawn from the space from the side or edge of the device.

This means that the end effector can be withdrawn from the side or edge of the device after lowering the wafer onto the surface and while the wafer is supported by the surface. Subsequently, a different end effector can be inserted into the space from the side or edge of the device and used to pick up the wafer from the surface.

Using different end effectors to lower the wafer onto the surface and to pick up the wafer from the surface may minimise a temperature change of the wafer caused by the end effectors.

For example, where an end effector loads hot wafers onto the surface for cooling, the end effector may be heated by the hot wafers. If the same end effector is used to pick up the wafers after the cooling, the end effector will have a higher temperature than the wafers and may heat the wafers.

In contrast, if a different end effector is used for picking up the wafers from the surface after the cooling, the temperature of the different end effector may be closer to the temperature of the wafers after the cooling and may therefore have less of an effect on the temperature of the wafers.

The device according to the first aspect of the present invention may include any one, or, where compatible, any combination of the following optional features.

Withdrawing the at least a distal part of the end effector from the space from the side of the device may comprise withdrawing the at least a distal part of the end effector from the device from the side of the device.

The side of the device may be or may comprise a peripheral side or edge of the device, or a boundary side or edge of the device, or a perimeter side or edge of the device, for example.

Changing the temperature of the wafer may comprise cooling the wafer.

Changing the temperature of the wafer may comprise reducing the temperature of the wafer.

The wafer may be a semiconductor wafer.

The wafer may have a diameter of 200mm, or 300mm, or 450mm.

The device may be for changing the temperature of a wafer having a predetermined diameter, or configured to change the temperature of a wafer having a predetermined diameter. The predetermined diameter may be 200mm, or 300mm, or 450mm.

The device may be configured or adapted to change the temperature of the wafer.

The surface being configured to support the wafer may mean that the surface is configured to support some or all of the weight of the wafer.

The surface being configured to support the wafer may mean that the surface is configured to contact the wafer.

The surface being configured to exchange heat with the wafer may mean that the surface and the wafer will exchange heat when the wafer is supported by the surface if there is a temperature difference between the surface and the wafer.

Exchanging heat with the wafer may comprise performing heat transfer with the wafer or transferring heat with the wafer.

Exchanging heat with the wafer may comprise receiving heat from the wafer.

Exchanging heat with the wafer may comprise exchanging thermal energy with the wafer.

Exchanging heat with the wafer may comprise receiving thermal energy from the wafer.

Exchanging heat with the wafer may comprise conduction of heat between the surface and the wafer.

Exchanging heat with the wafer may comprise conduction of heat from the wafer to the surface.

The surface may be a surface of a body of the device. The device may therefore comprise a body having the surface.

The surface may be a top surface of the body of the device.

The surface may comprise a thermally conductive material.

The surface may comprise aluminium.

The body may comprise aluminium.

The term space may mean a cut out, a recess, a gap, or an opening, for example.

The space may be or comprise a cut out, a recess, a gap, or an opening, for example.

Typically the space is a three-dimensional space.

The device comprising a space may mean that the device defines a space, or provides a space, or bounds a space, or forms a space, or encloses a space.

The space has a predefined or predetermined shape and/or a predefined or predetermined size.

The space is configured, for example positioned and/or shaped and/or sized to receive at least the distal part of the end effector when the end effector is used to lower the wafer onto the surface.

At least the distal part of the end effector may mean at least a distal end of the end effector.

The distal part of the end effector may mean a part of the end effector including the distal end of the end effector.

The distal end of the end effector may mean an opposite end of the end effector to an end of the end effector that is connected or attached to a robotic arm.

The distal end of the end effector may be a free end of the end effector.

The distal end of the end effector may be a longitudinal end of the end effector.

Typically the distal end of the end effector is an end of the end effector that is beneath the wafer when the end effector is used to support the wafer from beneath.

The distal part of the end effector may be a longitudinally distal part of the end effector.

The distal part of the end effector may mean the part of the end effector that is beneath (for example directly beneath) the wafer when the end effector is used to support the wafer from beneath.

The space may be configured to receive the part of the end effector that is beneath (for example directly beneath) the wafer when the end effector is used to support the wafer from beneath.

The distal part of the end effector may be a distal part of a longitudinal length of the end effector.

The distal part may be a distal portion, or distal length, of the end effector.

The space may be configured to receive the end effector. Any references herein to "at least the distal part of the end effector" may therefore be replaced with "the end effector" and vice versa, unless incompatible. Similarly, any references herein to "at least a distal part of an end effector" may be replaced with "an end effector" and vice versa, unless incompatible.

The space may be configured to receive a majority of a length of the end effector.

The space may be configured to receive substantially a whole length of the end effector.

The space may be configured to receive a whole length of the end effector.

The space may be adapted to receive at least the distal part of the end effector when the end effector is used to lower the wafer onto the surface.

Receiving at least the distal part of the end effector means that at least the distal part of the end effector is located inside the space.

At least the distal part of the end effector may be fully contained inside the space when at least the distal part of the end effector is received in the space.

Typically the space is located below the surface, so that at least the distal part of the end effector is located below the surface when at least the distal part of the end effector is received in the space.

Typically the whole end effector is located below the surface when at least the distal part of the end effector is received in the space.

The space being located below the surface may mean that the space is located lower in the device than the surface, and/or at a lower level in the device than the surface.

At least the distal part of the end effector being received in the space may mean that a whole thickness or whole height or whole depth of at least the distal part of the end effector (perpendicular to a main plane of the wafer and/or perpendicular to a main plane of the end effector) is received in the space, for example so that the distal part of the end effector does not protrude upwards out of the space.

At least the distal part of the end effector being received in the space may mean that a whole thickness or whole height or whole depth of at least the distal part the end effector (perpendicular to a main plane of the wafer and/or perpendicular to a main plane of the end effector) is below the surface, or lower than the surface.

At least the distal part of the end effector being received in the space may mean that the whole end effector is below the surface or lower than the surface.

Typically the space has a depth that is greater than a depth of at least the distal part the end effector.

The end effector supports the wafer from beneath. The end effector may be configured to support the wafer from beneath, or used to support the wafer from beneath.

The end effector supports the wafer from beneath. Therefore, the end effector is underneath the wafer when the wafer is supported by the end effector. Therefore, the end effector is underneath the wafer when the end effector lowers the wafer onto the surface.

The end effector may be an end effector of an arm, such as a robotic arm.

The end effector may be a robot end effector, or a robot arm end effector, or a robotic arm end effector.

The end effector may be connected to, attached to, or mounted on the robotic arm.

The end effector may be connected to, or attached to, or mounted on the robotic arm at an opposite end of the end effector to the distal part of the end effector.

The end effector may have one or more prongs or forks for supporting the wafer from beneath. The one or more prongs may be positioned or provided at the distal end of the end effector.

The space may be configured to receive at least the distal part of the end effector by at least the distal part of the end effector being lowered into the space. In particular, at least the distal part of the end effector may be lowered into the space from above.

In other words, the space is accessible and/or open to the end effector from above, so that at least the distal part of the end effector can be lowered into the space.

The space may be formed in a top surface or upper surface or main face of the device.

The space may be formed in the surface, or adjacent to the surface.

Typically, when at least the distal part of the end effector is received in the space at least the distal part of the end effector is below the surface.

The space may therefore be configured to receive at least the distal part of the end effector below the surface when the end effector is used to lower the wafer onto the surface.

The space may be configured to receive at least the distal part of the end effector with at least the distal part of the end effector located or positioned below the surface, or lower than the surface.

In such an arrangement at least the distal part of the end effector may not protrude above the surface, and may not contact the wafer on the surface.

The space may be configured so that a height or thickness or depth of at least the distal part of the end effector (perpendicular to a main plane of the wafer and/or perpendicular to a main plane of the end effector) can be fully received in the space.

Typically, the space is configured to receive at least the distal part of the end effector so that the end effector is no longer in contact with the wafer placed on the surface.

Typically, the space is configured to receive at least the distal part of the end effector so that the end effector no longer supports the wafer placed on the surface from beneath.

At least the distal part of the end effector may be lowered into the space as the wafer is being lowered onto the surface by the end effector.

The space may extend into the device from the surface.

The space may be open at the surface, and/or accessible at the surface.

The space may be open from above, and/or accessible from above.

The space may have an opening in or on the surface, or next to or adjacent to the surface.

Therefore, at least the distal part of the end effector can be lowered into the space from above the device.

The space extends from or to a side or side edge or edge of the device.

The device may have a main face or main surface and one or more sides.

The device may have a top face or top surface and one or more sides.

The main face, or main surface, or top face, or top surface may comprise the surface.

The main face, or main surface, or top face, or top surface, may be substantially horizontal, or horizontal.

The one or more sides may be substantially vertical, or vertical.

The space may be open at the side or side edge or edge of the device.

The space may have an open side at the side or side edge or edge of the device.

The space may have an open side at the top of the device.

The space is accessible at the side or side edge or edge of the device.

The end effector is removable from the space from the side or side edge or edge of the device.

The end effector is insertable into the space from the side or side edge or edge of the device.

The space is configured so that the end effector can be removed from the space from the side or side edge or edge of the device.

The at least a distal part of the end effector may be withdrawn from the space from the side or edge of the device by moving the end effector laterally or horizontally relative to the device.

The at least a distal part of the end effector may therefore be lowered into the space from a top of the space and then withdrawn from the space from the side or edge of the device.

The at least a distal part of the end effector may be lowered into the space in a substantially vertical (or vertical) direction, and then withdrawn from the space from the side or edge of the device in a substantially horizontal (or horizontal) direction.

The at least a distal part of the end effector may be withdrawn from the space from the side or edge of the device by moving the end effector in a longitudinal direction of the end effector.

The side of the device may be substantially perpendicular to, or perpendicular to, the surface.

The at least a distal part of the end effector may be withdrawn from the space from the side or edge of the device by moving the end effector parallel to the surface and/or parallel to a wafer supported by the surface.

The space may be shaped and/or sized so that the at least a distal part of the end effector can be withdrawn from the space from the side or edge of the device.

Part of a length of the end effector may extend out of the space from the side or side edge or edge of the device.

When at least the distal part of the end effector is received in the space, part of a longitudinal length of the end effector may protrude from the device from the side or side edge or edge of the device. In other words, part of a longitudinal length of the end effector may not be received in the space. Alternatively, part of a robotic arm attached to the end effector may protrude from the side of the device.

The space may be formed in a top surface or upper surface or main face of the device and may extend to a side or side edge of the device.

The space may be open and/or accessible to the end effector at or from the top surface or upper surface of the device and at or from the side or side edge of the device.

A minimum width of the space (parallel to a plane of the wafer and/or a plane of the device) may be greater than a maximum width of at least the distal part of the end effector. This may mean that the end effector can be withdrawn laterally from the space, for example via the side of the device, even when the distal end of the end effector is a widest part of the end effector.

The width is perpendicular to a longitudinal direction of the space and/or the end effector.

A shape of an upper opening of the space may correspond to, and/or match, a shape of at least the distal part of the end effector.

The surface may extend over and/or above part of the space.

This may maximise a surface area of the surface and therefore maximise the exchange of heat with the wafer.

When the at least a distal part of the end effector is withdrawn from the space from the side or edge of the device, part of the at least a distal part of the end effector may therefore pass underneath the surface where the surface extends over and/or above part of the space.

A groove or channel or trench may be formed where the surface extends over and/or above part of the space.

When the at least a distal part of the end effector is withdrawn from the space from the side or edge of the device, the at least a distal part of the end effector may be moved along the groove or channel or trench.

This may enable the end effector to be removed laterally from the space, whilst maximising a surface area of the surface.

The surface may extend over and/or above part of a longitudinal side of the space.

A longitudinal side of the space may mean a side that is parallel to a longitudinal length of the end effector.

A groove or channel or trench may therefore be formed at part of the longitudinal side of the space.

The part of the longitudinal side of the space may be at, or adjacent to, or proximal to, the side of the device.

The part of the longitudinal side of the space may be at, or adjacent to, or proximal to, a proximal end or edge of the space.

The surface may extend over part of both longitudinal sides of the space.

A groove or channel or trench may therefore be formed at part of both longitudinal sides of the space.

A minimum outer width of the space may be greater than a maximum outer width of the at least a distal part of the end effector.

This may enable the end effector to be withdrawn from the space from the side or edge of the device.

The width may be parallel to the surface and/or parallel to the wafer supported by the surface.

A more distal part of the at least a distal part of the end effector may have a greater width than a more proximal part of the at least a distal part of the end effector.

For example, the end effector may have a wider forked or pronged portion at the distal end of the end effector.

The space may have a uniform or substantially uniform outer width.

A minimum outer width of the space may be greater than a width of a pronged or forked portion of the end effector at a distal end of the end effector.

An opening of the space in the surface or a top surface of the device may have a smaller area than a main part of the space below the surface or top surface.

This may allow the end effector to be laterally removed from the space even where a distal end of the end effector is a widest part of the end effector, for example where the distal part of the end effector is fork-shaped.

The device may be for passively cooling the wafer.

Passively cooling may mean that the device does not include any powered cooling means/device, such as a thermoelectric cooling device, such as a Peltier.

Passively cooling may mean that the device does not actively dissipate heat.

Alternatively, the device may be for actively cooling the wafer.

Actively cooling may mean that the device includes a powered cooling device, such as a thermoelectric cooling device, such as a Peltier.

The device may comprise one or more thermoelectric modules.

The one or more thermoelectric modules may be for cooling the surface, either directly or indirectly.

The device may comprise a plate or a block, for example a plate or a block of material.

The surface may be a surface of the plate or the block.

The plate or the block may comprise the surface.

The plate or the block may comprise the space.

The space may be formed in the plate or the block.

The space may be formed in an upper surface of the plate or the block.

The space may be formed in the surface.

The space may be a cut out or recess formed in the plate or block. The plate or block may therefore comprise the cut out or recess.

The device may comprise a thermal plate, a thermal transfer plate, or a thermalisation plate.

The surface may be a surface of the thermal plate, thermal transfer plate, or thermalisation plate.

The thermal plate, thermal transfer plate, or thermalisation plate may comprise the surface.

The thermal plate, thermal transfer plate, or thermalisation plate may comprise the space.

The space may be formed in the thermal plate, thermal transfer plate, or thermalisation plate.

The space may be formed in an upper surface of the thermal plate, thermal transfer plate, or thermalisation plate.

The space may be formed in the surface.

The space may be a cut out or recess formed in the thermal plate, thermal transfer plate, or thermalisation plate. The thermal plate, thermal transfer plate, or thermalisation plate may therefore comprise the cut out or recess.

The device may comprise a vacuum clamp for vacuum clamping the wafer to the device.

The device may comprise a vacuum clamping arrangement or mechanism for vacuum clamping the wafer to the device.

The device may comprise one or more openings or holes or grooves or channels (or a groove or channel) in the surface to which a low pressure or vacuum can be applied, or in which a low pressure or vacuum can be generated, so as to clamp the wafer to the surface and/or so as to hold the wafer against the surface.

The device may comprise one or more openings or holes or passageways or conduits (or an opening or hole or passageway or conduit) connected to the one or more grooves or channels, or fluidly connected to the one or more grooves or channels, or in fluid communication with the one or more grooves or channels, through which air can be sucked from the one or more grooves or channels, for example by one or more pumps, so as to cause the low pressure in the one or more grooves or channels.

The one or more grooves or channels may be arcuate.

The one or more grooves or channels may be ring-shaped, or substantially ring-shaped, or a segment of a ring.

There may be more than one groove, for example two grooves.

Where there is more than groove, the grooves may be connected together.

The one or more grooves may be or comprise a double groove.

The one or more grooves may be or comprise an arcuate loop or a curved loop.

The groove may have an inner groove portion and an outer groove portion. The inner and outer groove portions may both be arcuate. The inner and outer groove portions may be connected together to form a loop or continuous path. The inner groove portion may be a radially inner groove portion and the outer groove portion may be a radially outer groove portion.

The one or more grooves may comprise an inner groove and an outer groove. The inner and outer grooves may both be arcuate. The inner and outer grooves may be connected together to form a loop or continuous path. The inner groove may be a radially inner groove and the outer groove may be a radially outer groove.

Providing both inner and outer grooves or groove portions may allow for successful vacuum clamping of a wider range of curved or bowed wafers. In particular, an inner groove or groove portion may allow for the vacuum clamping of positively bowed wafers (wafers that curve upwards away from the surface), whereas an outer groove or groove portion may allow for the vacuum clamping of negatively bowed wafers (wafers that curve downwards towards the surface). Therefore, providing both inner and outer grooves or groove portions may allow for successful vacuum clamping of a wide range of both positively and negatively bowed wafers.

The device may comprise a baseplate and a top-plate that is attached to the baseplate.

The top-plate may be detachable from the baseplate.

The top-plate may be attached to the baseplate by one or more screws or bolts.

An advantage of having a top-plate attached to the baseplate is that different top-plates made of different materials can be provided for different applications, for example depending on the characteristics of the wafer. For example, a material of the top-plate may be selected based on properties such as whether or not the material is electrically conductive and/or chemically resistant, and/or based on wear characteristics of the material, and/or based on a cost of the material.

The baseplate may comprise the space.

For example, the space may be formed in the baseplate, for example in a top surface of the baseplate.

For example, the baseplate may comprise a cut out or recess.

At least the distal part of the end effector may be received in the space in the baseplate when the end effector is used to lower the wafer onto the surface.

The top-plate may comprise a cut out or gap or opening corresponding to the space or forming part of the space, so that at least the distal part of the end effector can be lowered into the space, or the part of the space, in the baseplate.

The top-plate may comprise the surface. For example, the surface may be a top surface of the top-plate.

The top-plate may be thinner than the baseplate. This may reduce machining time for the top-plate and require less material for the top-plate, which may reduce the cost of the top-plate.

The top-plate may be made of a different material to the baseplate.

A variety of different materials may be used for the top-plate, depending on various different selection criteria. For example, selection criteria for the material for the top-plate may comprise one or more of: low surface roughness (to reduce risk of particle generation); resistant to wear (to ensure long life of the top-plate); low risk of particle generation (to prevent particle accumulation on the wafer); low metal content (to prevent contamination on the wafer backside); thermally conductive (to allow cooling of the wafer); and electrically conductive (to allow the top-plate to be grounded and prevent charge accumulation).

The top-plate may comprise or be made of a single material. For example, the top-plate may comprise a homogeneous material. Alternatively, the top-plate may comprise or be made of more than one material. For example, the top-plate may comprise a first material at least part of which is coated with a second material. The material or coating can be chosen to suite different applications.

Suitable low wear, clean coatings include anodizing, diamond like coating (of which there is a large variety of proprietary coatings from various manufacturers), silicon, silicon oxide, titanium nitride, and silicon carbide, for example.

Generally aluminium is advantageous as a material for a main body of the top-plate due to its high thermal conductivity. However, other materials can be used instead of aluminium.

The top-plate may therefore comprise aluminium.

A surface coating may be applied to a top surface of the top-plate (for example a top surface of an aluminium top-plate) to generally improve surface wear behaviour (for example DLC, SiC, TiN).

Generally, an underside of the top-plate is not coated, in order to ensure good thermal contact to the baseplate and/or a thermal interface material between the top-plate and the baseplate. An underside of the top-plate may therefore be bare aluminium, for example.

Generally the baseplate also comprises a material with high-thermal conductivity, such as aluminium.

The baseplate may therefore comprise or be made of aluminium.

Since the baseplate generally does not come into direct contact with the wafer, contamination of the wafer by the material of the baseplate may be less of a concern. Therefore, it may not be necessary to apply a coating to the baseplate.

For example, a top surface of the baseplate may be anodized aluminium.

A bottom surface of the baseplate may be uncoated, for example bare aluminium, to ensure good thermal contact.

The baseplate may have a greater thermal mass than the top-plate.

The device may comprise thermal interface material between the baseplate and the top-plate.

This may improve thermal transfer between the baseplate and the top-plate.

The thermal interface material may be in the form of a film.

The thermal interface material may comprise graphite or silicone, and/or be graphite or silicone based.

The thermal interface material may be electrically conductive. This may prevent charge from being accumulated in the top-plate.

The device may comprise a thermal break between the baseplate and another part of the device.

The device may comprise plural thermal breaks between the baseplate and one or more other parts of the device.

For example, one or more thermal breaks may be positioned around at least part of an edge of the baseplate between the baseplate and a housing or enclosure of the device.

The one or more thermal breaks may comprise air-gaps.

The one or more thermal breaks may comprise thermally insulating material.

The device may comprise a plurality of limiting elements or parts that are configured to limit lateral movement of the wafer relative to the surface.

For example, the device may comprise a plurality of bumps or protrusions for limiting lateral movement of the wafer relative to the surface.

For example, the limiting elements or parts may be raised above the surface, or extend or protrude above the surface.

The limiting elements or parts may be positioned and/or arranged to contact a radially outer edge of the wafer if the wafer is laterally displaced relative to the surface.

The limiting elements or parts may be positioned or located around a periphery or outer edge of the surface.

The limiting elements or parts may be positioned in the surface.

Each of the limiting elements may be positioned a distance X from a centre of the surface, wherein X is greater than a radius of a wafer that the device is configured to receive. For example, for a wafer having a radius of 150mm, each of the limiting elements may be positioned at a distance of more than 150mm from the centre of the surface.

Where the device comprises a top-plate and a baseplate as discussed above, the limiting elements or parts may be provided at the tops of pillars or rods or pins that are connected to or attached to the baseplate.

The pillars or rods or pins may pass through holes in the top-plate.

One or more grooves or channels may be provided between the top-plate and the baseplate, for example sandwiched between the top-plate and the baseplate, for example to create a sealed pipe or passageway or channel between the top-plate and the baseplate.

A pipe or passageway or channel may be provided between the top-plate and the baseplate.

One or more holes may be provided through the top-plate from the surface of the top-plate to the one or more grooves or channels or pipe or passageway.

For example, the one or more grooves or channels or pipe or passageway may be in the form of a ring or a segment of a ring. The one or more holes may therefore be arranged on the surface of the top-plate in the shape of a ring or a segment of a ring.

A hole or opening may be provided in the one or more grooves or channels or pipe or passageway through which air can be sucked from the one or more grooves or channels so as to generate a low pressure in the one or more grooves or channels. This low pressure will also be applied to the holes provided through the top-plate so as to attract or hold the wafer to the device.

According to a second aspect of the present invention there is provided a device for changing the temperature of a wafer, the device comprising a baseplate and a top-plate that is attached to the baseplate, wherein the top-plate comprises a surface configured to support the wafer and to perform heat transfer with the wafer.

The device according to the second aspect of the present invention may include any of the features of the first aspect of the present invention, unless incompatible with the features of the second aspect of the present invention.
the top-plate may be thinner than the baseplate.

The top-plate may comprise a different material to the baseplate.

The baseplate may have a greater thermal mass than the top-plate.

The device may comprise thermal interface material between the baseplate and the top-plate.

The device may comprise a thermal break between the baseplate and another part of the device.

The top-plate may have any of the features of the top-plate in the first aspect of the present invention, unless incompatible. For example, the surface of the top-plate may have any of the features of the surface described above.

The baseplate may have any of the features of the baseplate in the first aspect of the present invention, unless incompatible. For example, the baseplate may include the space described above.

According to a third aspect of the present invention there is provided a mass metrology apparatus comprising:
the device according to the first or second aspect of the present invention;
a measurement chamber; and
a weighing device inside the measurement chamber.

The apparatus according to the third aspect of the present invention may include any of the features of the first or second aspects of the present invention, unless incompatible with the features of the third aspect of the present invention.

The mass metrology apparatus may be for measuring a mass or the wafer, or may be configured to measure the mass of the wafer.

The measurement chamber may be a weighing chamber.

The weighing device may be for performing a weight measurement on the wafer, or configured to perform a weight measurement on the wafer.

The weighing device may be for generating measurement output indicative of the weight of a wafer loaded on the weighing device, or configured to generate measurement output indicative of the weight of a wafer loaded on the weighing device.

The weighing device may comprise a pan such as a weighing pan or a balance pan for supporting the wafer.

The device may be thermally coupled to the measurement chamber.

The device may be thermally coupled to an outside of the measurement chamber.

The device may be mounted on the measurement chamber, for example mounted on an outside of the measurement chamber.

The device may be attached to the measurement chamber, for example attached to an outside of the measurement chamber.

Since the device of the present invention may be thinner than if actuator pins, or other similar intermediate mechanisms for receiving the wafer from the end effector and subsequently lowering the wafer onto the surface, were included, the surface may be closer to the measurement chamber in the present invention. This may enable the temperature of the surface to be more closely matched to the temperature of the measurement chamber.

The apparatus may further comprise a robotic arm having an end effector for transporting the wafer.

The end effector may be configured to support the wafer from beneath when the end effector is used to transport the wafer.

The end effector may have any of the features of the end effector mentioned above.

The space in the device is configured to receive at least the end part of the end effector of the robotic arm when the end effector is used to lower the wafer onto the surface.

The apparatus may comprise:
a first robotic arm having a first end effector; and
a second robotic arm having a second end effector;
wherein the apparatus is configured to use the first end effector to lower the wafer onto the surface of the device; and
wherein the apparatus is configured to use the second end effector to pick up the wafer from the surface of the device.

The apparatus may comprise:
a robotic arm having a first end effector and a second end effector;
wherein the apparatus is configured to use the first end effector to lower the wafer onto the surface of the device; and
wherein the apparatus is configured to use the second end effector to pick up the wafer from the surface of the device.

According to a fourth aspect of the present invention there is provided an apparatus comprising the device according to the first aspect of the present invention and the end effector.

The apparatus according to the fourth aspect of the present invention may include any of the features of the first, second or third aspects of the present invention, unless incompatible with the features of the fourth aspect of the present invention.

The apparatus may comprise a robot arm or robotic arm having or comprising the end effector.

The apparatus may comprise a measurement chamber and a weighing device inside the measurement chamber.

The invention includes the combination of the aspects and preferred features described except where such a combination is clearly impermissible or expressly avoided.

### Brief description of the drawings

Embodiments of the present invention will now be discussed, by way of example only, with reference to the accompanying Figures, in which:
FIG. 1 shows a semiconductor wafer mass metrology apparatus according to a first embodiment of the present invention;
FIG. 2 shows a semiconductor wafer mass metrology apparatus according to a second embodiment of the present invention;
FIG. 3 shows a device for changing the temperature of a wafer according to a third embodiment of the present invention;
FIG. 4 shows an end effector that can be used in embodiments of the present invention;
FIG. 5 shows a device for changing the temperature of a wafer according to a fourth embodiment of the present invention;
FIG. 6 shows part of the device for changing the temperature of a wafer according to the fourth embodiment of the present invention;
FIG. 7 shows part of the device for changing the temperature of a wafer according to the fourth embodiment of the present invention;
FIG. 8 shows a device for changing the temperature of a wafer according to a fifth embodiment of the present invention;
FIG. 9 shows part of the device for changing the temperature of a wafer according to the fifth embodiment of the present invention;
FIG. 10 shows part of the device for changing the temperature of a wafer according to the fifth embodiment of the present invention;
FIG. 11 shows part of the device for changing the temperature of a wafer according to the fifth embodiment of the present invention; and
FIG. 12 shows part of the device for changing the temperature of a wafer according to the fifth embodiment of the present invention.

### Detailed description of the preferred embodiments and further optional features of the invention

Aspects and embodiments of the present invention will now be discussed with reference to the accompanying figures. Further aspects and embodiments will be apparent to those skilled in the art. All documents mentioned in this text are incorporated herein by reference.

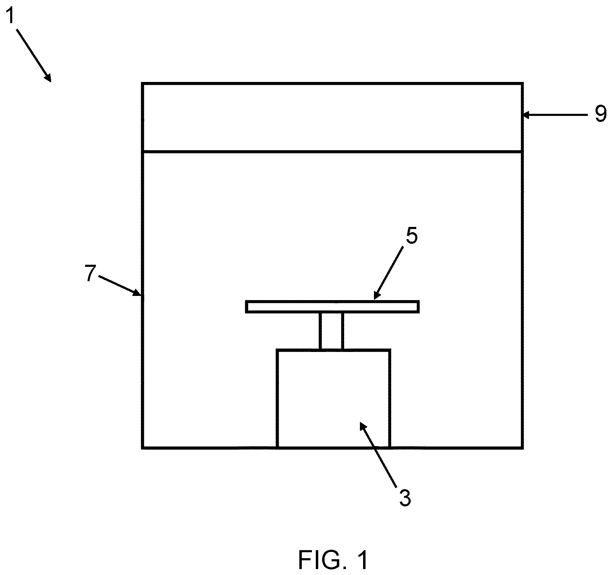

FIG. 1 shows a semiconductor wafer mass metrology apparatus 1 according to a first embodiment of the present invention.

The semiconductor wafer mass metrology apparatus 1 is configured to measure a mass of a wafer, or a change in the mass of a wafer.

The semiconductor wafer mass metrology apparatus 1 comprises a weighing device 3 having a weighing pan 5 for receiving a semiconductor wafer and for supporting the wafer during a weight measurement performed on the wafer by the weighing device 3. The weighing device 3 is configured to provide measurement output indicative of the weight of a wafer loaded on the weighing pan 5. For example, the weighing device 3 may measure the weight of the wafer loaded on the weighing pan 5, or a change in the weight of the wafer, or a difference between the weight of the wafer and a reference weight.

The weighing device 3 is located within a weighing chamber 7, which forms an enclosed environment around the weighing device 3. For example, the weighing chamber 7 may maintain a substantially uniform air density, air pressure and air temperature of the air around the weighing device 3. The weighing chamber 7 has an opening (not shown), e.g. a suitably sized slot in a side-wall of the weighing chamber 7, to allow a wafer to be transported into the weighing chamber 7, by an end effector of a robotic arm, and positioned on the weighing pan 5. When not in use, the opening may be covered by an openable door or covering (not shown) to allow the weighing chamber 7 to be substantially closed or sealed when performing measurements using the weighing device 3.

A temperature changing part 9 for changing a temperature of the wafer is positioned on top of the weighing chamber 7.

The temperature changing part 9 may comprise a plate or block. The plate or block may be made of, or comprise, a material having a good thermal conductivity, for example Al.

The temperature changing part 9 preferably has a high thermal mass, so that its temperature changes slowly and little when it is supplied with heat, and/or a good lateral thermal conductivity, so that it maintains a substantially uniform temperature across its upper surface.

The temperature changing part 9 may comprise or be a thermal transfer plate, or thermal plate, or thermalisation plate.

The temperature changing part 9 is positioned directly on top of the weighing chamber 7, so that there is a good thermal contact between the temperature changing part 9 and the weighing chamber 7. The temperature changing part 9 is in direct physical contact with the weighing chamber 7. The temperature changing part 9 may be attached or fixed to the weighing chamber 7, for example using one or more bolts (not shown) and/or a thermally conductive bonding layer (not shown).

As a result of the good thermal contact between the temperature changing part 9 and the weighing chamber 7, the temperature changing part 9 may be substantially in thermal equilibrium with the weighing chamber 7 and therefore may have substantially the same temperature as the weighing chamber 7 (when a heat load on the temperature changing part 9 is low). The weighing device 3 may also be in thermal equilibrium with the weighing chamber 7 and therefore may also have substantially the same temperature as the weighing chamber 7. As such, the temperature changing part 9 may be substantially in thermal equilibrium with the weighing device 3 and therefore may have substantially the same temperature as the weighing device 3 (when a heat load on the temperature changing part 9 is low).

In use, a wafer to be measured is firstly positioned on the temperature changing part 9 to reduce its temperature. A vacuum clamping mechanism may be provided to vacuum clamp the wafer to the temperature changing part 9 in order to achieve a good thermal contact between the temperature changing part 9 and the wafer. The temperature changing part 9 may therefore comprise a vacuum clamp for clamping a wafer to the temperature changing part 9. Thermal equilibrium between the wafer and the temperature changing part 9 may be achieved in a short time period, for example less than 0.01°C temperature difference between the temperature changing part 9 and the wafer within 20 seconds.

The wafer may be positioned on the temperature changing part 9 for a predetermined period of time sufficient to achieve thermal equilibrium between the wafer and the temperature changing part 9. Usually the temperature changing part 9 and the weighing chamber 7 are in thermal equilibrium with each other (when a heat load on the temperature changing part 9 is low), such that the wafer is brought to the same temperature as the temperature of the weighing chamber 7.

Typically, the temperature of the wafer is higher than the temperature of the temperature changing part 9 and the temperature of the weighing chamber 7, and therefore typically the temperature changing part 9 cools the wafer (reduces the temperature of the wafer).

After the wafer has been cooled by the temperature changing part 9, it is transported from the temperature changing part 9 into the weighing chamber 7 and positioned on the weighing pan 5 of the weighing device 3, for measurement.

The weighing device 3 is used to perform a weight measurement on the wafer. For example, the weighing device 3 may measure a weight of the wafer.

The apparatus 1 is configured to perform a calculation to calculate the mass of the wafer based on the result of the weight measurement. The calculation may comprise performing a buoyancy correction to correct for a buoyancy force on the wafer from the air in the weighing chamber 7. For example, the weighing chamber 7 may comprise one or more sensors for detecting a temperature and/or pressure and/or humidity of the air in the weighing chamber 7, in order to calculate a buoyancy force on the wafer.

Of course, in other embodiments the temperature changing part 9 may be located in a different position relative to the weighing chamber 7 than that illustrated in FIG. 1. For example, in another embodiment the temperature changing part 9 may not be mounted on the weighing chamber 7 and instead may be positioned to a side of the weighing chamber 7 and/or located separately to the weighing chamber 7. In such an alternative embodiment the temperature changing part 9 may not be thermally coupled to the weighing chamber 7 and therefore may not be substantially in thermal equilibrium with the weighing chamber 7.

The temperature changing part 9 may include or have a temperature sensor for sensing a temperature of the temperature changing part 9.

Other features of the first embodiment will be discussed below following the discussion of the second embodiment of the present invention.

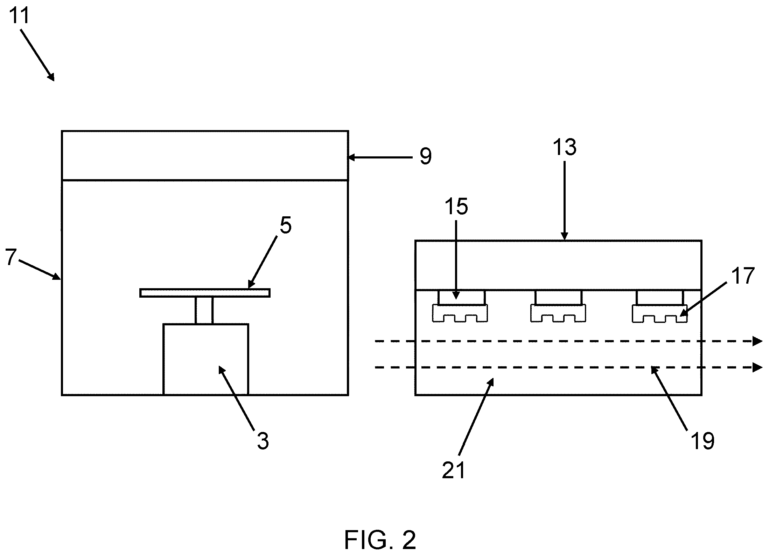

FIG. 2 shows a semiconductor wafer mass metrology apparatus 11 according to a second embodiment of the present invention.

The semiconductor wafer mass metrology apparatus 11 of FIG. 2 differs from the semiconductor wafer mass metrology apparatus 1 of FIG. 1 in that it further comprises a second temperature changing part 13.

The second temperature changing part 13 may comprise a plate or block. The plate or block may be made of, or comprise, a material having a good thermal conductivity (for example Al).

The second temperature changing part 13 may further comprise a plurality of Peltier devices 15 attached on a bottom side of the plate or block, and/or in contact with the bottom side of the plate or block. Each Peltier device 15 has a heat sink 17 attached to it, for example on the bottom side thereof. An air flow 19 can be provided in a region 21 beneath the bottom side of the plate or block in order to remove heat from the Peltier devices 15 and from the heat sinks 17. Of course, the configuration of the air flow may be different to that shown in FIG. 2. For example, air may be blown out of the bottom of the region 21 by a fan. Alternatively, an air flow may not be provided in other embodiments. In addition, a number of the Peltier devices 15 and/or heat sinks 17 may be different to that illustrated in FIG. 2.

The second temperature changing part 13 may include or have a temperature sensor for sensing a temperature of the second temperature changing part 13. A temperature of the second temperature changing part 13 may be controlled so that it is equal to, or within a predetermined range of, a target temperature. For example, the plurality of Peltier devices 15 may be operated or controlled so that the sensed temperature is equal to, or within a predetermined range of, a target temperature.

In FIG. 2 the second temperature changing part 13 is shown as being positioned to the right-hand side of the weighing chamber 7. However, in other embodiments the second temperature changing part 13 can be positioned differently, for example to a different side, and/or above or below the weighing chamber 7, or closer to or further away from the weighing chamber 7 than illustrated in FIG. 2. In other embodiments, the second temperature changing part 13 may be attached or connected, directly or indirectly, to the temperature changing part 9 and/or to the weighing chamber 7.

In use, a wafer transporter, for example an end effector of a robotic arm of an Equipment Front End Module (EFEM), is used to remove a wafer from a Front Opening Unified Pod (FOUP) (not shown), or alternatively from another processing apparatus (not shown), and to transport the wafer to the second temperature changing part 13 and position the wafer on the second temperature changing part 13. When the wafer is removed from the FOUP (or the other processing apparatus) it may have a temperature of approximately 70°C. For example, the wafer may have been processed at a processing station of a semiconductor device production line, which may have heated the wafer to a temperature of 400 to 500°C, before the wafer was loaded into the FOUP.

When the wafer is positioned on the second temperature changing part 13, heat is conducted from the wafer to the second temperature changing part 13 so that the temperature of the wafer is decreased. Depending on how long the wafer is positioned on the second temperature changing part 13, the wafer and the second temperature changing part 13 may achieve thermal equilibrium (e.g. so that they have substantially the same temperature). In order to prevent the temperature of the second temperature changing part 13 from increasing due to the heat load from the wafer, the Peltier devices 15 are operable to actively dissipate the heat load removed from the wafer from the second temperature changing part 13. In other words, electrical power is supplied to the Peltier devices 15 to cause them to act as active heat pumps that transfer heat from their upper surfaces in contact with the plate or block to their lower surfaces to which the heat sinks 17 are attached. The Peltier devices 15 may instead be referred to as thermoelectric modules.

An air flow 19 is provided in the region 21 beneath the plate or block in which the Peltier devices 15 and the heat sinks 17 are positioned in order to remove heat from the Peltier devices 15 and the heat sinks 17. The heat removed from the wafer using the second temperature changing part 13 is therefore transported and dissipated away from the weighing chamber 7 of the wafer mass metrology apparatus 11 by the air flow 19, so that this heat has no effect on the temperature of the weighing chamber 7. In other words, heat is actively dissipated from the second temperature changing part 13.

The second temperature changing part 13 is operated to remove a bulk of a heat load from the wafer, so that the temperature of the wafer is reduced to close to the desired temperature of the wafer when it is positioned on the weighing pan 5.

Typically, it is desired to substantially match the temperature of the wafer to the temperature of the weighing chamber 7, so that there is substantially no temperature difference between the wafer and the weighing chamber 7 (and therefore substantially no temperature difference between the wafer and the weighing device 3) when the wafer is loaded on the weighing pan 5. In this embodiment, the second temperature changing part 13 may cool the wafer to within ±1°C of the temperature of weighing chamber 7. For example, where the weighing chamber 7 has a temperature of 20°C, the second temperature changing part 13 may cool the wafer to a temperature of (20±1)°C. However, in other embodiments the amount of cooling provided by the second temperature changing part 13 may be different to this.

Once the wafer has been cooled to a temperature close to the desired temperature using the second temperature changing part 13, it is transported to the temperature changing part 9 using a wafer transporter comprising a robotic arm with an end effector for supporting the wafer.

The temperature changing part 9 may be referred to as a first temperature changing part.

As discussed above, when the wafer is positioned on the temperature changing part 9 there is good thermal contact between the wafer and the temperature changing part 9. Therefore, the wafer is cooled by heat being conducted from the wafer to the temperature changing part 9. Depending on the length of time that the wafer is positioned on the temperature changing part 9, the wafer and the temperature changing part 9 may become substantially in thermal equilibrium, so that they have substantially the same temperature. In this embodiment, the wafer may be positioned on the temperature changing part 9 for a period sufficient to achieve thermal equilibrium, for example 60 seconds. In this embodiment, the second temperature changing part 13 may cool the wafer to within ±0.1°C of the temperature of weighing chamber 7
The wafer has already had the bulk of its heat load removed by the second temperature changing part 13 before it is positioned on the temperature changing part 9. Therefore, the thermal load on the temperature changing part 9 during the temperature equalisation is very low, and the temperature of the temperature changing part 9 and the weighing chamber 7 (which have a high thermal mass) may therefore remain substantially constant during the temperature equalisation (when a heat load on the temperature changing part 9 is low). In addition, relatively little heat has to be exchanged to bring the wafer into thermal equilibrium with the temperature changing part 9.

Therefore, with the present embodiment it may be possible to more accurately/precisely equalise the temperature of the wafer to the desired temperature, because the steps of removing the bulk of the heat load from the wafer and equalising the temperature of the wafer have been separated.

When the temperature of the wafer is substantially equalised to the temperature of the temperature changing part 9 (e.g. when the wafer has been on the temperature changing part 9 for a predetermined period of time) the wafer is transported by a wafer transporter comprising a robotic arm with an end effector from the temperature changing part 9 to the weighing pan 5. The weighing device 3 is then used to provide measurement output indicative of the weight of the wafer.

The arrangements illustrated in FIGS. 1 and 2 are illustrative arrangements only, and other configurations of the weighing chamber and/or temperature changing part or parts are possible in the present invention and will be apparent to the skilled person from the above disclosure and the following disclosure.

For example, in a modified version of the second embodiment described above the temperature changing part 9 may be omitted, so that the temperature of the wafer is changed using only the second temperature changing part 13.

In the first or second embodiments described above one or both of the temperature changing part 9 and the second temperature changing part 13 is a device for changing the temperature of a wafer according to the present invention.

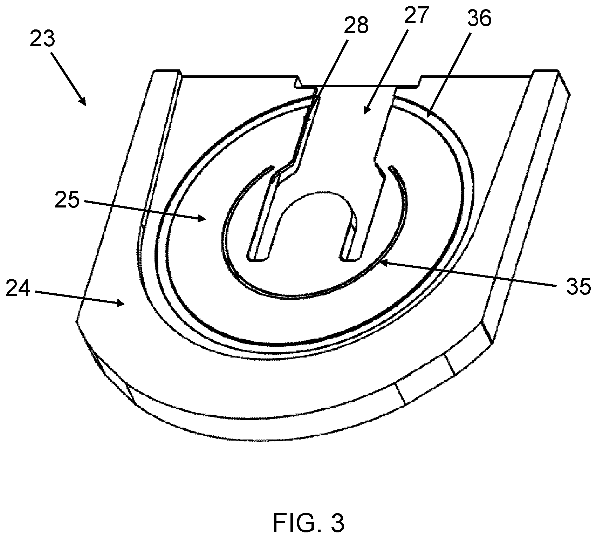

FIG. 3 is an example of a device 23 for changing the temperature of a wafer according to a third embodiment of the present invention. The device 23 of this embodiment can be used as the temperature changing part 9 in embodiments 1 and 2 described above, for example, or in other semiconductor wafer mass metrology apparatus.

The device 23 is for passively cooling a wafer. In other words, the device 23 does not include any powered cooling means/devices, such as a Peltier device.

The device 23 comprises a plate or block 24. The plate or block 24 is made of, or comprises, a material having a high thermal mass and high thermal conductivity. The plate or block 24 may be made of, or comprise, a metal, such as aluminium.

As illustrated in FIG. 3, the plate or block 24 has a surface 25 that is configured to support a wafer when the wafer is placed on the plate or block 24 on the surface 25. The surface 25 is an upper surface of the plate or block 24, and therefore an upper surface of the device 23.

The surface 25 is configured to contact the wafer to support the wafer and to exchange heat or thermal energy with the wafer to change the temperature of the wafer. In other words, the surface 25 is for performing heat transfer with the wafer to change the temperature of the wafer.

The surface 25 may be referred to as a heat transfer surface of the plate or block 24 or the device 23.

The device 23 may be for changing the temperature of a wafer having a predetermined diameter, for example 200mm, or 300mm, or 450mm. The surface 25 may therefore be configured to support a wafer having the predetermined diameter.

As illustrated in FIG. 3, the plate or block 24 comprises a cut out 27 that is configured to receive an end effector 29 of a robotic arm when the end effector 29 is used to lower the wafer onto the surface 25 while supporting the wafer from beneath.

The cut out 27 is formed in a top surface of the plate or block 24 of the thermal transfer plate 23, such as the surface 25, such that the end effector 29 can be lowered into the cut out 27 from the top surface when the end effector 29 is used to lower the wafer onto the surface 25 while supporting the wafer from beneath.

The cut out 27 is configured, for example positioned and/or shaped and/or sized to receive the end effector 29 when the end effector 29 is used to lower the wafer onto the surface 25.

In particular, the cut out 27 is positioned lower in the plate or block 24 than the surface 25, so that the end effector 29 can be lowered into the cut out 27 when lowering the wafer onto the surface 25 so that the end effector 29 is received in the cut out 27 when the wafer is placed on the surface 25.

In particular, the cut out 27 is located below the surface 25 in the plate or block 24.

The cut out 27 extends into the plate or block 24 from the surface 25 and is accessible and/or open to the end effector 29 from the surface 25.

The cut out 27 has an open side at a side of the device 23.

The cut out 27 also extends to a side of the plate or block 24 and is accessible and/or open to the end effector 29 at the side of the plate or block 24.

As shown in FIG. 3, the surface 25 extends over or above part of both longitudinal sides of the cut out 27 so that a groove or trench 28 is formed along part of both longitudinal sides of the cut out 27.

This means that an area of an opening of the cut out 27 formed in the surface 25 is smaller than an area of a main body of the cut out 27 below the surface 25.

The groove or trench 28 allows the end effector 29 to be withdrawn laterally from the cut out 27 via the open side of the cut out 27 even though a distal end of the end effector 29 is a widest part of the end effector.

A minimum width of a main part of the cut out 27 below the surface 25 is larger than a maximum width of the end effector 29 received in the cut out 27. This enables the end effector 29 to be withdrawn laterally from the cut out 27.

When the end effector 29 is received in the cut out 27 the end effector 29 is below the surface 25. In other words, when the end effector 29 is received in the cut out 27 the end effector 29 is lower in the plate or block 24 than the surface 25. In such an arrangement the end effector 29 does not protrude above the surface 25, and does not contact the wafer on the surface 25.

The whole end effector 29 is below the surface 25, or lower than the surface 25, when the end effector 29 is received in the cut out 27.

The cut out 27 is configured so that the end effector 29 can be lowered into the cut out 27. For example, an outer shape of the cut out 27 may be configured to receive an outer shape of the end effector 29.

The cut out 27 is configured so that a whole thickness or height or depth the end effector 29 (perpendicular to a main plane of the wafer and/or perpendicular to a main plane of the end effector 29) can be fully received in the cut out 27 when the end effector 29 is used to place the wafer on the surface 25, so that the wafer is fully supported by the surface 25 and is no longer in contact with the end effector 29. In other words, the cut out 27 is configured so that the thickness or height or depth of the end effector can be fully received, or contained, or housed in the cut out 27 below the surface 25 when the wafer is placed on the surface 25.

This may be achieved by the cut out 27 extending into the device 23 from the surface 25 by a distance greater than a thickness of the end effector 29 (the thickness being perpendicular to a main face of the end effector 29 and/or perpendicular to a main plane of the wafer).

The cut out 27 is configured, for example shaped and/or positioned, so that once the end effector 29 has been received in the cut out 27, the end effector 29 can be withdrawn laterally from the device 23 while the wafer is supported by the surface 25.

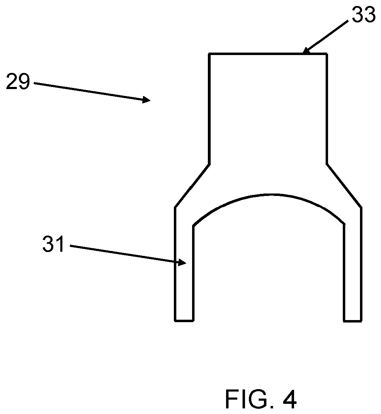

An example of such an end effector 29 is illustrated in FIG. 4. As illustrated in FIG. 4, the end effector 29 comprises two prongs or forks 31 that are configured to contact an underside of the wafer to support the weight of the wafer from beneath. The wafer can therefore be carried by the end effector 29.

An end 33 of the end effector 29 opposite to the two prongs or forks 31 is configured to be attached to a robotic arm, so that the end effector 29 can be moved by the robotic arm to move the wafer.

As shown in FIG. 4, the distal end of the end effector 29 is wider than the proximal end of the end effector 29.

Of course, a different end effector may be used instead of the end effector 29 illustrated in FIG. 4. For example, a number of prongs or forks may be different to that illustrated in FIG. 4, such as one or more prongs or forks.

The device 23 may further comprise or be provided with a vacuum clamp for clamping the wafer to the device 23. For example, the device 23 may comprise a groove or channel 35 in the surface 25 from which air can be sucked, for example by one or more pumps, so as to create a low pressure between the device 23, and/or the surface 35 of the device 23, and the wafer so as to clamp the wafer to the surface 25.

The device 23 may further comprise a passageway connected to the groove or channel 35 through which air can be sucked from the groove or channel 35, for example by a pump, so as to create a low pressure in the groove or channel 35.

The groove or channel 35 is arcuate, or ring-shaped, or shaped like a segment of a ring.

As shown in FIG. 3, the surface 25 comprises a further groove or channel 36 positioned radially outwards of the groove or channel 35.

The further groove or channel 36 is arcuate, or ring-shaped. The further groove or channel 36 is concentric with the groove or channel 35 and has a greater diameter.

The further groove or channel 36 is configured to receive a protruding edge bead that may be formed on the surface of the wafer adjacent to the perimeter of the wafer. Such an edge bead may be formed on the surface of the wafer around the wafer edge by deposition during processing of the wafer. In the absence of the further groove or channel 36, this edge bead may prevent good contact from being made between the surface 25 and the surface of the wafer.

The further groove or channel 36 may have a radius slightly less than a radius of the wafer that the device 23 is configured to receive. For example, the further groove or channel 36 may have a radius of 1mm to 8mm less than the wafer that the device 23 is configured to receive.

For example, the device may be configured to receive a wafer having a diameter of 300mm, and therefore a radius of 150mm. The further groove or channel 36 may therefore have a radius in the range of 142mm to 149mm, preferably in the range of 144mm to 148mm.

Alternatively, instead of the further groove or channel 36, there may be a step down in the surface 25 when moving radially outward on the surface 25 at the expected position of the edge bead. In other words, a radially outer part of the surface 25 may be set-back or recessed relative to a radially inner part of the surface 25, so that there is a step down between the radially inner part and the radially outer part of the surface 25.

The step down may be arcuate, or ring-shaped.

As for the further groove or channel 36, the step down may have a radius slightly less than a radius of the wafer that the device 23 is configured to receive. For example, the further groove or channel may have a radius of 1mm to 8mm less than the wafer that the device 23 is configured to receive.

When used in a semiconductor wafer mass metrology apparatus, for example as illustrated in in FIGS. 1 and 2, the device 23 may be provided on, or be integral with, or mounted on, or attached to, an outer surface of the weighing chamber 7. For example, the device 23 may be attached or fixed or bolted to an outer surface of the weighing chamber 7, for example using bolts having a high thermal conductivity.

In particular, the plate or block 24 may be provided on, or be integral with, or mounted on, or attached to the outer surface of the weighing chamber 7.

In such an arrangement, the device 23 may be substantially in thermal equilibrium with the weighing chamber 7, such that the device 23 has substantially the same temperature as the weighing chamber 7.

The plate or block 24 may be a thermal plate, a thermal transfer plate, or a thermalisation plate.

In other embodiments, the device 23 may comprise one or more thermoelectric modules (for example Peltier devices) attached to the plate or block 24 or mounted on the plate or block 24 for changing a temperature of the surface. In other words, in other embodiments the device may be an active cooling device. Such an active cooling device can be used as the second temperature changing part in embodiment 2 described above, for example, or in other semiconductor wafer mass metrology apparatus.

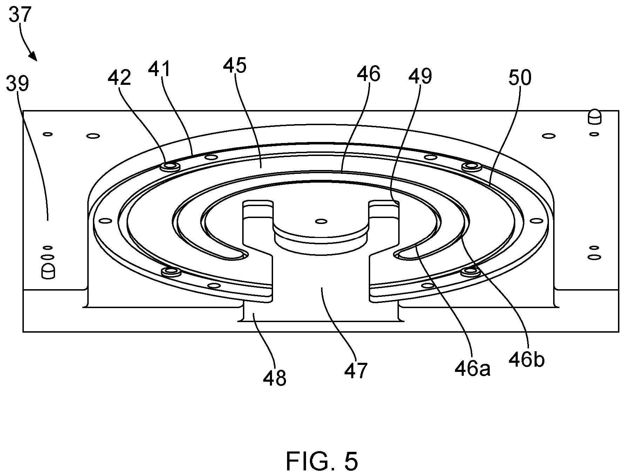

FIGS. 5 to 7 show a device 37 for changing the temperature of a wafer according to a fourth embodiment of the present invention.

The device 37 comprises a baseplate 39 and a top-plate 41 that is attached to the baseplate 39, for example by one or more bolts or screws.

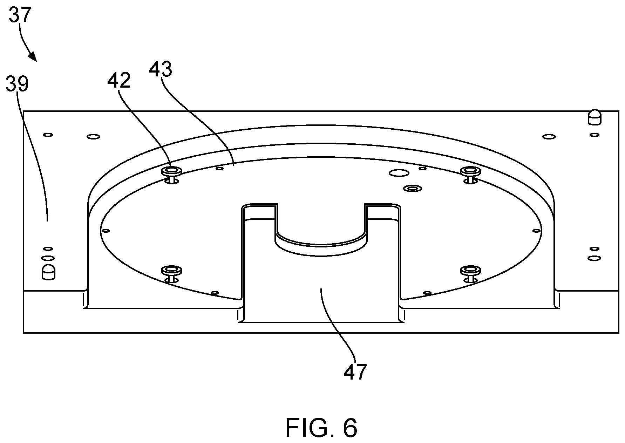

FIG. 6 shows the device 37 with the top-plate 41 removed. As shown in FIG. 6, the device 37 comprises thermal interface material 43 between the top-plate 41 and the baseplate 39, to improve heat transfer between the top-plate 41 and the baseplate 39. Of course, in other embodiments the thermal interface material 43 may be omitted.

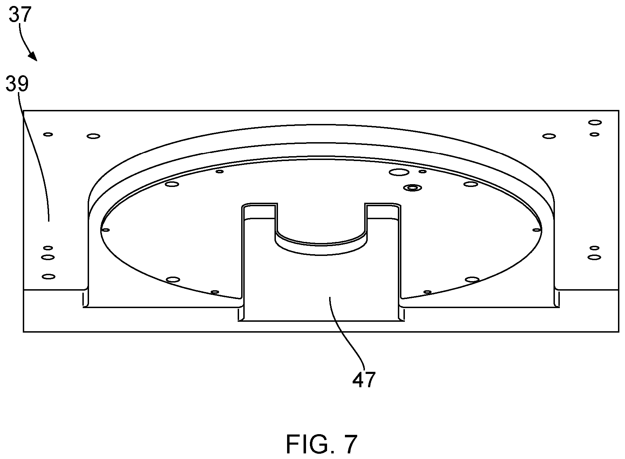

FIG. 7 shows the device 37 with both the top-plate 41 and the thermal interface material 43 removed. As shown in FIG. 7, in this embodiment the thermal interface material 43 is received in a recess in a top surface of the baseplate 39. However, in other embodiments, such a recess may be omitted and the thermal interface material may be positioned on the top surface of the baseplate 39 without such a recess and extend above the top surface of the baseplate 39.

The top-plate 41 comprises a surface 45 that is configured to support a wafer when the wafer is placed on the device 37 on the surface 45. The surface 45 is an upper surface of the device 37.

As shown in FIG. 5, for example, the device 37 may comprise one or more bumps or protrusions 42 raised above the surface 45 and located around a periphery or outer edge of the surface 45. The bumps or protrusions 42 may limit lateral movement of the wafer on the surface 45, for example while vacuum clamping is being applied to the wafer or the vacuum clamping is being released. In particular, the bumps or protrusions 42 may be configured to come into contact with a radially outer edge of the wafer if the wafer is displaced laterally from a central position on the surface 45, so as to limit the lateral movement of the wafer.

As shown in FIG. 6, for example, the bumps or protrusions 42 are provided at the tops of pillars or rods that pass through holes in the top-plate 41. The bumps or protrusions 42 may therefore be referred to a bump pillars, for example.

The pillars or rods are connected to, or attached to, the baseplate 39.

In this embodiment, there are four of the bumps or protrusions 42 arranged in a square arrangement. Of course, in other embodiments there may be a different number of the bumps or protrusions, for example three or more.

The surface 45 is configured to contact the wafer to support the wafer and to exchange thermal energy with the wafer to change the temperature of the wafer. In other words, the surface 45 is for performing heat transfer with the wafer to change the temperature of the wafer.

The surface 45 may be referred to as a heat transfer surface of the device 37.

The surface 45 may have any of the features of the surface 25 described above, where compatible.

The device 37 may comprise a groove or channel 46 in the surface 45 from which air can be sucked, for example by one or more pumps, so as to create a low pressure between the top-plate 41, and/or the surface 35 of the top-plate 41, and the wafer so as to clamp the wafer to the surface 45.

The device 37 may further comprise a passageway connected to the groove or channel 46 through which air can be sucked from the groove or channel 46, for example by a pump, so as to create a low pressure in the groove or channel 46.

In this embodiment, the groove or channel 46 is a double groove or channel, comprising a radially inner groove or groove portion 46a and a radially outer groove or groove portion 46b. As discussed above, the radially inner and radially outer groove portions 46a and 46b allow for successful vacuum clamping of a wide range of curved or bowed wafers.

The radially inner and radially outer groove portions 46a and 46b are both arcuate and are connected together to form a loop or continuous path.

As shown in FIG. 5, the surface 45 comprises a further groove or channel 50 positioned radially outwards of the groove or channel 46.

The further groove or channel 50 may correspond to the further groove or channel 36 in FIG. 3, and may have any of the features of the further groove or channel 36 discussed above. In addition, the further groove or channel 50 may also be replaced with a step down as discussed above for the further groove or channel 36, and may have any of the features of that step down discussed above.

The bumps or protrusions 42 are positioned adjacent to the further groove or channel 50, radially outwards of the further groove or channel 50.

As shown in FIGS. 5 to 7, a cut out 47 is formed in the baseplate 39.

The cut out 47 is configured (for example shaped and/or sized and/or positioned) to receive an end effector 29 of a robotic arm when the end effector 29 is used to lower the wafer on the surface 45 while supporting the wafer from beneath.

The cut out 47 is formed in a top surface of the baseplate 39 such that the end effector 29 can be lowered into the cut out 47 from the top surface when the end effector 29 is used to lower the wafer onto the surface 45 while supporting the wafer from beneath.

The cut out 47 is open or accessible to the end effector 29 from above.

The top-plate 41 comprises a gap or opening 49 above the cut out 47 in the baseplate 39, so that the end effector 29 can pass through the gap or opening 49 to enter the cut out 47.

The cut out 47 is positioned lower in the device 37 than the surface 45, so that the end effector 29 can be lowered into the cut out 47 when lowering the wafer onto the surface 45 so that the end effector 29 is received in the cut out 47.

The cut out 47 extends to an edge of the device 37. The cut out 47 is open or accessible at the edge of the device 37.

The cut out 47 has an open side at the side of the device 37.

When the end effector 29 is received in the cut out 47 the end effector 29 is below the surface 45. In other words, when the end effector 29 is received in the cut out 47 the end effector 29 is lower in the device 37 than the surface 45.

When the end effector 29 is received in the cut out 47 the whole of the end effector 29 is below the surface 45.

The cut out 47 has a depth that is greater than a depth of the end effector 29.

The cut out 47 is configured so that the end effector 29 can be lowered into the cut out 47. In particular, an outer shape of the cut out 47 is configured to receive an outer shape of the end effector 29.

The cut out 47 is configured so that a depth or thickness or height of the end effector 29 can be fully received in the cut out 47 when the end effector 29 is used to place the wafer on the surface 45, so that the wafer is fully supported by the surface 45 and is no longer in contact with the end effector 29. In other words, the cut out 47 is configured so that the depth or thickness or height of the end effector 29 can be fully received, or contained, or housed in the cut out 47 below the surface 45 when the wafer is placed on the surface 45.

This may be achieved by the cut out 47 extending into the baseplate 39 by a distance greater than a thickness of the end effector 29 (the thickness being perpendicular to a main face of the end effector 29).

The cut out 47 is configured, for example shaped and/or positioned, so that once the end effector 29 has been received in the cut out 47, the end effector 29 can be withdrawn laterally from the device 37 while the wafer is supported by the surface 45.

As shown in FIG. 5, the top-plate 41 extends over or above part of both longitudinal sides of the cut out 47 in the baseplate 39, so that a groove or trench 48 is formed along part of both longitudinal sides of the cut out 47.

This means that an area of the gap or opening 49 formed in the top-plate 41 is smaller than an area of the cut out 47 in the baseplate 39.

The groove or trench 48 allows the end effector 29 to be withdrawn laterally from the cut out 47 via the open side of the cut out 47 even though a distal end of the end effector 29 is a widest part of the end effector 29.

A minimum width of the cut out 47 is larger than a maximum width of the end effector 29 received in the cut out 47. This enables the end effector 29 to be withdrawn laterally from the cut out 47.

The device 37 may be for passively cooling a wafer.

The baseplate 39 may be made of a different material to the top-plate 41.

The baseplate 39 is thicker than the top-plate 41.

The baseplate 39 may have a larger thermal mass than the top-plate 41.

The device 37 may be used as the temperature changing part 9 in the first or second embodiment, for example.

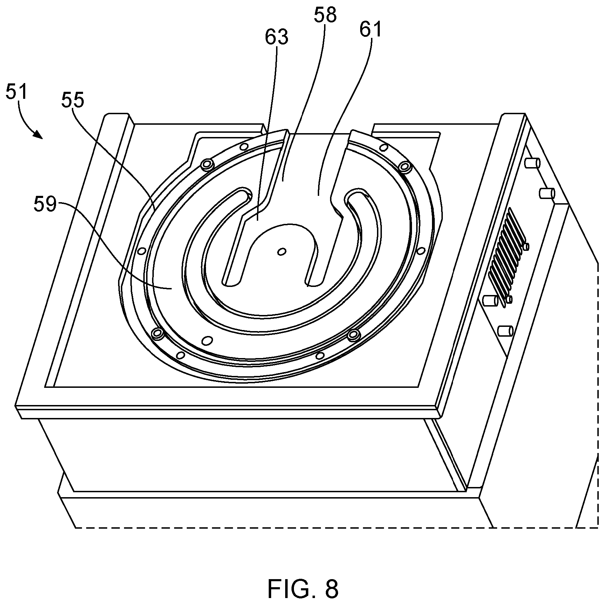

FIGS. 8 to 12 show a device 51 for changing the temperature of a wafer according to a fourth embodiment of the present invention.

As shown in FIGS. 8 to 12, the device 51 comprises a baseplate 53 and a top-plate 55 that is attached to the baseplate 53, for example by one or more bolts or screws.

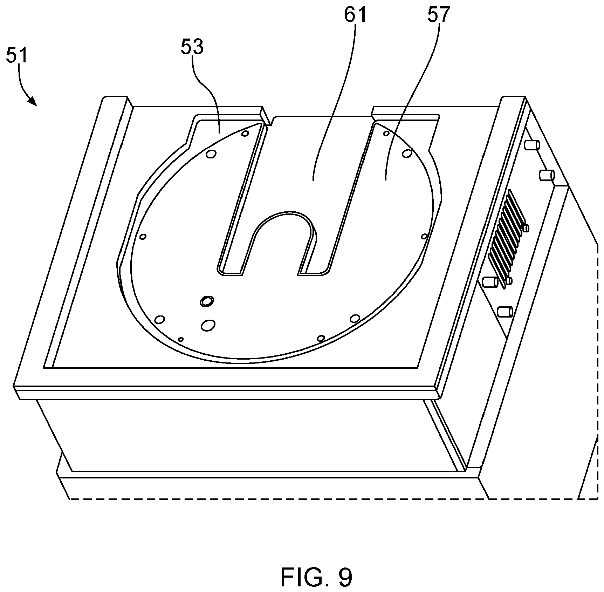

FIG. 9 shows the device 51 with the top-plate 55 removed. As shown in FIG. 9, the device 51 comprises thermal interface material 57 between the top-plate 55 and the baseplate 53, to improve heat transfer between the top-plate 55 and the baseplate 53. Of course, in other embodiments the thermal interface material 57 may be omitted,

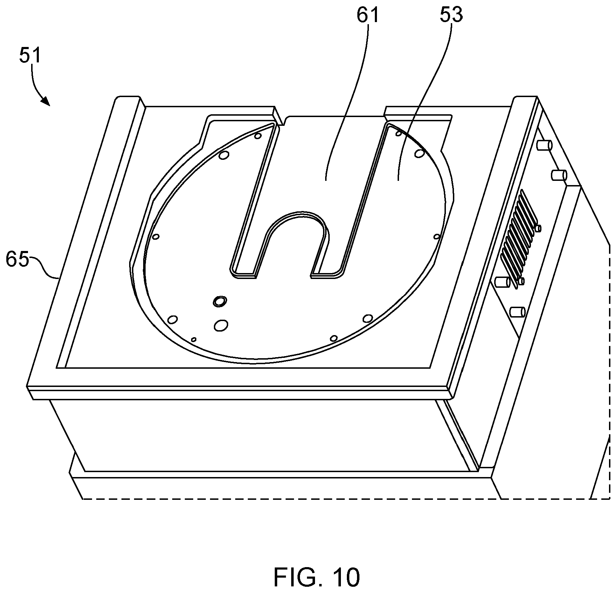

FIG. 10 shows the device 51 with both the top-plate 55 and the thermal interface material 57 removed. As shown in FIG. 10, in this embodiment the thermal interface material 57 is received in a recess in a top surface of the baseplate 53. However, in other embodiments, such a recess may be omitted and the thermal interface material may be positioned on the top surface of the baseplate 53 without such a recess and extend above the top surface of the baseplate 53.

The top-plate 55 comprises a surface 59 that is configured to support a wafer when the wafer is placed on the device 51 on the surface 59. The surface 59 is an upper surface of the device 51.

The surface 59 is configured to contact the wafer to support the wafer and to exchange thermal energy with the wafer to change the temperature of the wafer. In other words, the surface 59 is for performing heat transfer with the wafer to change the temperature of the wafer.

The surface 59 may be referred to as a heat transfer surface of the device 51.

The surface 59 may have any of the features of the surface 25 or the surface 45 described above, where compatible.

As shown in FIGS. 8 to 11, a cut out 61 is formed in the baseplate 53.

The cut out 61 is configured (for example shaped and/or sized and/or positioned) to receive an end effector 29 of a robotic arm when the end effector 29 is used to lower the wafer onto the surface 59 while supporting the wafer from beneath.

The cut out 61 is formed in a top surface of the baseplate 53 such that the end effector 29 can be lowered into the cut out 61 from the top surface when the end effector 29 is used to lower the wafer onto the surface 59 while supporting the wafer from beneath.

The top-plate 55 comprises a gap or opening 63 above the cut out 61 in the baseplate 53, so that the end effector 29 can pass through the gap or opening 63 to enter the cut out 61.

The cut out 61 is positioned lower in the device 51 than the surface 59, so that the end effector 29 can be lowered into the cut out 61 when lowering the wafer onto the surface 59 so that the end effector 29 is received in the cut out 61.

The cut out 61 extends to an edge of the device 51.

The cut out 61 is open and/or accessible at the edge of the device 51.

When the end effector 29 is received in the cut out 61 the end effector 29 is below the surface 59. In other words, when the end effector 29 is received in the cut out 61 the end effector 29 is lower in the device 51 than the surface 59.

When the end effector 29 is received in the cut out 61 the whole of the end effector 29 is below the surface 59.

The cut out 61 has a depth that is greater than a depth of the end effector 29.

The cut out 61 is configured so that the end effector 29 can be lowered into the cut out 61. In particular, an outer shape of the cut out 61 is configured to receive an outer shape of the end effector 29.

The cut out 61 is configured so that a depth or thickness or height of the end effector 29 can be fully received in the cut out 61 when the end effector 29 is used to place the wafer on the surface 59, so that the wafer is fully supported by the surface 59 and is no longer in contact with the end effector 29. In other words, the cut out 61 is configured so that the depth or thickness or height of the end effector 29 can be fully received, or contained, or housed in the cut out 61 below the surface 59 when the wafer is placed on the surface 59.

This may be achieved by the cut out 61 extending into the baseplate 53 by a distance greater than a thickness of the end effector 29 (the thickness being perpendicular to a main face of the end effector 29).

The cut out 61 is configured, for example shaped and/or positioned, so that once the end effector 29 has been received in the cut out 61, the end effector 29 can be withdrawn laterally from the device 51 while the wafer is supported by the surface 59.

As shown in FIG. 8, the top-plate 55 extends over or above part of both longitudinal sides of the cut out 61 in the baseplate 53, so that a groove or trench 58 is formed along part of both longitudinal sides of the cut out 61.

This means that an area of the gap or opening 63 formed in the top-plate 55 is smaller than an area of the cut out 61 in the baseplate 53.

The groove or trench 58 allows the end effector 29 to be withdrawn laterally from the cut out 61 via the open side of the cut out 61 even though a distal end of the end effector 29 is a widest part of the end effector 29.

A minimum width of the cut out 61 is larger than a maximum width of the end effector 29 received in the cut out 61. This enables the end effector 29 to be withdrawn laterally from the cut out 61.

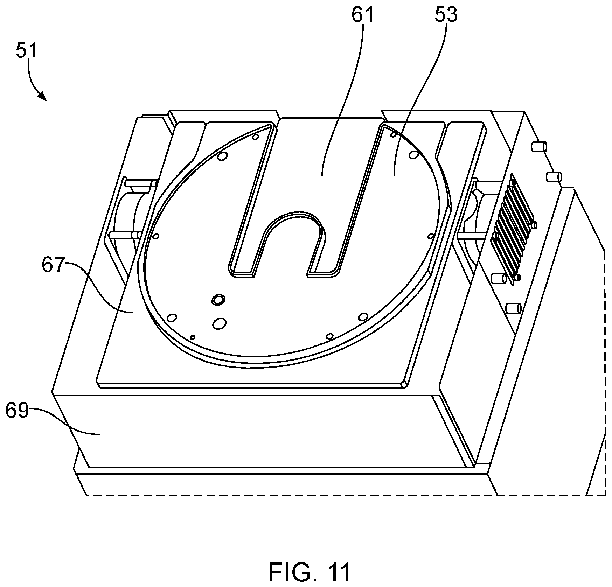

FIG. 11 shows the device 51 with a frame portion 65 that surrounds the baseplate 53 removed. As shown in FIG. 11, thermal breaks 67 are positioned between an outer edge of the baseplate 53 and a housing 69 of the device 51. The thermal breaks 69 improve thermal isolation of the baseplate 53 from the housing 69, meaning that a temperature of the housing 69 may be less affected by a temperature of the baseplate 53.

The thermal breaks 67 may comprise thermally insulating material. In addition, or alternatively, the thermal breaks 67 may comprise air gaps.

The thermal breaks 67 may extend around at least part of a periphery or edge of the baseplate 53.

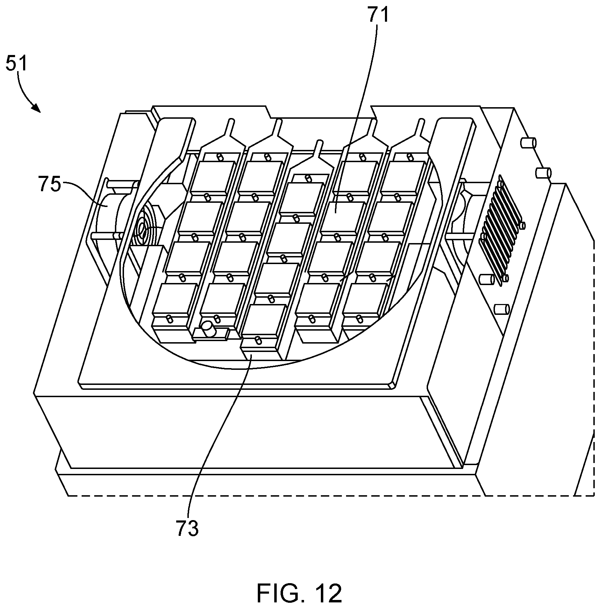

FIG. 12 shows the device 51 with the baseplate 53 removed. As shown in FIG. 12, a plurality of thermoelectric modules 71, for example Peltier devices, are positioned beneath the baseplate 53 in the device 51. When the baseplate 53 is in position in the device 51, the thermoelectric modules 71 are in contact with the baseplate 53, and/or connected to the baseplate 53.

The thermoelectric modules 71 can be operated to actively cool the baseplate 53, and therefore to indirectly cool the top-plate 55.

Heat sinks 73 are attached to bottom surfaces of the thermoelectric modules 71, for dissipating heat from the thermoelectric modules 71.

Furthermore, a fan 75 is provided for generating an air flow over or around the thermoelectric modules 71 and/or the heat sinks 73 in order to dissipate heat from the thermoelectric modules 71 and/or the heat sinks 73

The device 51 is therefore for actively cooling a wafer.

The baseplate 53 may be made of a different material to the top-plate 55.

The baseplate 53 is thicker than the top-plate 55.

The baseplate 53 may have a larger thermal mass than the top-plate 55.

The device 51 may be used as the second temperature changing part 13 in the first or second embodiment, for example.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.
The following numbered paragraphs (paras.) contain further statements of various aspects and embodiments of the present invention:
1. A device for changing the temperature of a wafer, the device comprising:
   a surface that is configured to support the wafer and to exchange heat with the wafer, and
   a space that is configured to receive at least a distal part of an end effector, which is used to support the wafer from beneath, when the end effector is used to lower the wafer onto the surface,
   wherein the space extends from or to a side of the device; and
   wherein the space is configured so that the at least a distal part of the end effector can be withdrawn from the space from the side of the device.
2. The device according to para. 1, wherein the surface extends over part of the space.
3. The device according to para. 2, wherein a groove or channel is formed where the surface extends over the part of the space.
4. The device according to para. 2 or 3, wherein the surface extends over part of a longitudinal side of the space.
5. The device according to para. 4, wherein the surface extends over part of both longitudinal sides of the space.
6. The device according to any of the preceding paras., wherein a minimum outer width of the space is greater than a maximum outer width of the at least a distal part of the end effector.
7. The device according to any of the preceding paras., wherein a more distal part of the at least a distal part of the end effector has a greater width than a more proximal part of the at least a distal part of the end effector.
8. The device according to any one of the preceding paras. , wherein the space is a cut out or a recess.
9. The device according to any one of the preceding paras., wherein the space is configured to receive at least the distal part of the end effector by at least the distal part of the end effector being lowered into the space.
10. The device according to any one of the preceding paras., wherein when at least the distal part of the end effector is received in the space at least the distal part of the end effector is below the surface.
11. The device according to any one of the preceding paras., wherein the space extends into the device from the surface.
12. The device according to any one of the preceding paras., wherein the device is for passively cooling the wafer.
13. The device according to any one of paras. 1 to 11, wherein the device is for actively cooling the wafer.
14. The device according to para. 13, wherein the device comprises one or more thermoelectric modules.
15. The device according to any one of the preceding paras., wherein the device comprises a plate or a block.
16. The device according to para. 15, wherein the plate or the block comprises the space.
17. The device according to para. 15 or para. 16, wherein the plate or the block comprises the surface.
18. The device according to any one of the preceding paras., wherein the device comprises a thermal plate, a thermal transfer plate, or a thermalisation plate.
19. The device according to any one of the preceding paras., wherein the device comprises a vacuum clamp for vacuum clamping the wafer to the device.
20. The device according to any one of the preceding paras., wherein the device comprises a baseplate and a top-plate that is attached to the baseplate.
21. The device according to para. 20, wherein the baseplate comprises the space.
22. The device according to para. 20 or para. 21, wherein the top-plate comprises the surface.
23. The device according to any one of paras. 20 to 22, wherein the top-plate is thinner than the baseplate.
24. The device according to any one of paras. 20 to 23, wherein the top-plate comprises a different material to the baseplate.
25. The device according to any one of paras. 20 to 24, wherein the baseplate has a greater thermal mass than the top-plate.
26. The device according to any one of paras. 20 to 25, wherein the device comprises thermal interface material between the baseplate and the top-plate.
27. The device according to any one of paras. 20 to 26, wherein the device comprises a thermal break between the baseplate and another part of the device.
28. A device for changing the temperature of a wafer, the device comprising a baseplate and a top-plate that is attached to the baseplate, wherein the top-plate comprises a surface configured to support the wafer and to exchange heat with the wafer.
29. The device according to para. 28, wherein the top-plate is thinner than the baseplate.
30. The device according to para. 28 or 29, wherein the top-plate comprises a different material to the baseplate.
31. The device according to any one of paras. 28 to 30, wherein the baseplate has a greater thermal mass than the top-plate.
32. The device according to any one of paras. 28 to 31, wherein the device comprises thermal interface material between the baseplate and the top-plate.
33. The device according to any one of paras. 28 to 32, wherein the device comprises a thermal break between the baseplate and another part of the device.
34. A wafer mass metrology apparatus comprising:
   the device according to any one of the preceding paras. ;
   a measurement chamber; and
   a weighing device inside the measurement chamber.
35. The wafer mass metrology apparatus according to para. 34, wherein the device is thermally coupled to the measurement chamber.
36. The wafer mass metrology apparatus according to para. 34 or para. 35, wherein the device is mounted on the measurement chamber.
37. The wafer mass metrology apparatus according to any one of paras. 34 to 36, wherein the apparatus further comprises a robotic arm having an end effector for transporting the wafer.
38. The wafer mass metrology apparatus according to any one of paras. 34 to 36, wherein the apparatus comprises:
   a first robotic arm having a first end effector; and
   a second robotic arm having a second end effector;
   wherein the apparatus is configured to use the first end effector to lower the wafer onto the surface of the device; and
   wherein the apparatus is configured to use the second end effector to pick up the wafer from the surface of the device.
39. The wafer mass metrology apparatus according to any one of paras. 34 to 36, wherein the apparatus comprises:
   a robotic arm having a first end effector and a second end effector;
   wherein the apparatus is configured to use the first end effector to lower the wafer onto the surface of the device; and
   wherein the apparatus is configured to use the second end effector to pick up the wafer from the surface of the device.

## Claims

1. A device for changing the temperature of a wafer, the device comprising a baseplate and a top-plate that is attached to the baseplate, wherein the top-plate comprises a surface configured to support the wafer and to exchange heat with the wafer.

2. The device according to claim 1, wherein the top-plate is thinner than the baseplate.

3. The device according to claim 1 or 2, wherein the top-plate comprises a different material to the baseplate.

4. The device according to any of the preceding claims, wherein the baseplate has a greater thermal mass than the top-plate.

5. The device according to any of the preceding claims, wherein the device comprises thermal interface material between the baseplate and the top-plate.

6. The device according to any of the preceding claims, wherein the device comprises a thermal break between the baseplate and another part of the device.
